# EUROPÄISCHE PATENTSCHRIFT

(11) **EP 2 778 253 B1**
(45) Veröffentlichungstag und Bekanntmachung des Hinweises auf die Patenterteilung: **24.10.2018**
(21) Anmeldenummer: 13195135.2
(22) Anmeldetag: 29.11.2013
(51) Int. Cl.: C23C 14/32, C23C 14/35, H01J 37/34, H01J 37/32, C23C 14/34

(54) **Zylinderförmige Verdampfungsquelle**
Cylindrical evaporation source
Source d'évaporation cylindrique

(30) Priorität: 26.02.2013 EP 13156790
(43) Veröffentlichungstag der Anmeldung: 17.09.2014
(73) Patentinhaber: Oerlikon Surface Solutions AG, Pfäffikon, 8808 Pfäffikon SZ (CH)
(72) Erfinder: Vetter, Jörg, 51469 Bergisch Gladbach (DE); Esser, Stefan, 50072 Aachen (DE); Müller, Jürgen, 57462 Olpe (DE); Erkens, Georg, 52070 Aachen (DE)
(74) Vertreter: Intellectual Property Services GmbH

(56) Entgegenhaltungen:
- EP-A1- 2 306 489
- EP-A2- 0 459 137
- EP-A2- 2 159 821
- JP-A- H 024 965
- US-A- 4 422 916
- US-A- 5 922 176
- US-A1- 2008 099 329

## Beschreibung

Die Erfindung betrifft eine zylinderförmige Verdampfungsquelle, insbesondere zur Verwendung in einem Sputterverfahren oder einem Vakuumverdampfungsverfahren, bevorzugt kathodisches Vakuumverdampfungsverfahren gemäss dem Oberbegriff des unabhängigen Anspruchs 1.

Zum Aufbringen von Schichten oder Schichtsystemen auf die unterschiedlichsten Substrate sind aus dem Stand der Technik eine ganze Reihe verschiedener chemischer, mechanischer und physikalischer Techniken bekannt, die je nach Anforderung und Einsatzgebiet ihre Berechtigung haben und entsprechende Vor- und Nachteile aufweisen.

Zum Aufbringen verhältnismässig dünner Schichten sind insbesondere Verfahren geläufig, bei welchen die Oberfläche eines Targets in einem Lichtbogen in die Dampfform überführt wird oder aber aus einer Oberfläche eines Targets Atome mittels ionisierter Teilchen in die Dampfform überführt werden, wobei sich der so gebildete Dampf dann als Beschichtung auf einem Substrat niederschlagen kann.

In einer üblichen Ausführungsform der Kathodenzerstäubung wird in einem Sputterprozess das Target an eine negative ungepulste Gleichstromspannungsquelle, oder z.B. an eine unipolare oder bipolare gepulste Quelle angeschlossen, oder im HIPIMS Mode betrieben, oder an eine hochfrequente Stromquelle angeschlossen. Die Entladung wird in der Regel durch Magnetsysteme verstärkt. Man spricht dann von Magnetronzerstäubung. Das Substrat ist das zu beschichtende Material und es befindet sich zum Beispiel dem Target gegenüber. Das Substrat kann geerdet, elektrisch schwimmend, vorgespannt, erhitzt, gekühlt sein oder einer Kombination hiervon unterworfen werden. In die Prozesskammer, die unter anderem die Prozesselektroden und das Substrat enthält, wird ein Prozessgas eingeführt, um eine Gasatmosphäre zu schaffen, in welchem eine Glimmentladung ausgelöst und aufrechterhalten werden kann. Die Gasdrücke reichen je nach Anwendung von wenigen Zehntel eines Pascals bis zu mehreren Pascal. Ein häufig verwendetes Zerstäubergas ist Argon.

Wenn die Glimmentladung ausgelöst wird, treffen positive Ionen auf die Oberfläche des Targets und lösen hauptsächlich neutrale Targetatome durch Stoßkraftübertragung heraus. Diese kondensieren auf dem Substrat, um dünne Filme zu bilden. Es gibt zusätzlich noch andere Partikel und Strahlungen, die durch das Target erzeugt werden und alle filmbildende Eigenschaften haben (Sekundärelektronen und Ionen, sowie Photonen). Die Elektronen und negativen Ionen werden gegen die Substratplattform beschleunigt und bombardieren diese und den wachsenden Film. In einigen Fällen wird ein zum Beispiel negatives Vorspannungspotential an den Substrathalter gelegt, so daß der wachsende Film dem Beschuss mit positiven Ionen ausgesetzt ist. Dieser Prozess ist auch als Vorspannungszerstäubung oder Ionenplattierung bekannt.

In bestimmten Fällen werden nicht nur Argon, sondern andere Gase oder Gasmischungen verwendet. Das schließt gewöhnlich einige Arten von Reaktionszerstäuberprozessen ein, in welchen eine Zusammensetzung durch Zerstäuben eines Metalltargets (z. B.Ti) in einem zumindest zum Teil reaktiven Reaktionsgas synthetisiert wird, um eine Zusammensetzung aus dem Metall und den Reaktionsgasarten (z.B. Titanoxide) zu bilden. Der Zerstäubungsertrag wird definiert als Zahl der aus der Targetoberfläche ausgestoßenen Atome pro einfallendem Ion. Es ist ein wesentlicher Parameter zur Charakterisierung des Zerstäuberprozesses.

Schätzungsweise ein Prozent der auf eine Targetoberfläche einfallenden Energie führt gewöhnlich zum Ausstoßen zerstäubter Partikel, 75 % der einfallender Energie führen zur Erwärmung des Target und der Rest wird zum Beispiel durch sekundäre Elektronen zerstreut, die das Substrat bombardieren und erhitzen können. Ein als Magnetron-Zerstäubung bekannter verbesserter Prozeß verwendet magnetische Felder zur Führung der Elektronen weg von der Substratoberfläche, wodurch die Wärmeeinwirkung reduziert wird.

Für ein gegebenes Targetmaterial werden die Auftragsrate und die Gleichmäßigkeit unter anderem durch die Systemgeometrie, die Targetspannung, das Zerstäubergas, den Gasdruck und die an die Prozesselektroden angelegte elektrische Leistung und insbesondere auch durch die stärke und Geometrie der im Prozess verwendeten magnetischen Felder beeinflusst.

Ein verwandtes physikalisches Beschichtungsverfahren ist die bekannte Lichtbogenverdampfung in ihren vielfältigen Ausgestaltungen.

Bei der Lichtbogenverdampfung wird das Targetmaterial durch die Wirkung von Vakuumlichtbögen verdampft. Das Targetquellenmaterial ist die Kathode in dem Lichtbogenkreis. Die Grundkomponenten eines bekannten Lichtbogenverdampfungssystems bestehen aus einer Vakuumkammer, einer Kathode und einem Lichtbogenstromanschluß, Teilen zum Zünden eines Lichtbogens auf der Kathodenoberfläche, einer Anode, einem Substrat und aus einem Stromanschluß für eine Substratvorspannung. Die Lichtbögen werden durch Spannungen im Bereich von zum Beispiel 15-50 Volt gehalten, abhängig von dem Targetkathodenmaterial, das verwendet wird. Typische Lichtbogenströme liegen im Bereich von 30-400 A. Die Lichtbogenzündung erfolgt durch die üblichen dem Fachmann bekannten Zündverfahren.

Die Verdampfung des Targetmaterials aus der Kathode, die das Target bildet, ergibt sich als Resultat eines kathodischen Lichtbogenpunktes, der sich im einfachsten Fall regellos auf der Kathodenfläche mit Geschwindigkeiten von üblicherweise 10 m/s bewegt. Die Lichtbogenpunktbewegung kann dabei aber auch mit Hilfe geeigneter Einschlußabgrenzungen und / oder magnetischer Felder gesteuert werden. Das Target-Kathodenmaterial kann zum Beispiel ein Metall oder eine Metalllegierung sein.

Der Lichtbogenbeschichtungsprozess ist erheblich verschieden von anderen physikalischen Dampfbeschichtungsprozessen. Der Kern der bekannten Lichtbogenprozesse ist der Lichtbogenpunkt, der ein Materialplasma erzeugt. Ein hoher Prozentsatz, z.B. 30 % - 100 % des von der Kathodenfläche verdampften Materials ist in der Regel ionisiert, wobei die Ionen in verschiedenen Ladungszuständen im Plasma, beispielsweise als Ti+, Ti2+, Ti3+ usw. existieren können. Die kinetische Energie der Ionen kann sich dabei im Bereich von z.B. 10 - 100 eV bewegen.

Diese Merkmale führen zu Beschichtungen, die von höchster Qualität sein können, und verglichen mit jenen Beschichtungen, die mit von anderen physikalischen Dampfbeschichtungsprozessen aufgetragen werden, bestimmte Vorteile aufweisen können.

Genau wie bei den oben beschriebenen Sputterverfahren spielt auch bei den Lichtbogenverdampfungsverfahren die Stärke und Geometrie der eingesetzten magnetischen Felder eine zentrale Rolle. Sie bestimmen unter anderem die Eigenschaften der Schichten, insbesondere auch deren Qualität in erheblichem Masse. Die magnetischen Felder können aber durchaus auch die Kosten der Verdampfungsprozesse, sei es ein Lichtbogenprozess oder ein Sputterverfahren, deutlich beeinflussen, beispielweise dadurch, dass die Beschichtungszeiten optimiert werden, oder die Ausnutzung der Targets bzw. des Targetsmaterials optimiert wird, oder indem sich die verwendeten Magnetfelder auf andere, dem Fachmann bekannte Parameter der Vorbereitungs- oder Beschichtungsverfahren positiv auswiken.

Die mittels Lichtbogenverdampfung aufgetragene Schichten zeigen meist über einen breiten Bereich der Beschichtungsbedingungen eine hohe Qualität. So lassen sich z. B. stöchiometrische Verbundfilme mit höchster Adhäsion und hoher Dichte herstellen, die über einen weiten Bereich des Reaktionsgasdruckes hohe Beschichtungsbeträge für Metalle, Legierungen und Zusammensetzungen mit exzellenter Beschichtungsgleichmäßigkeit liefern. Neben anderen ist ein weiterer Vorteil auch die verhältnismässig niedrigen Substrattemperaturen und die relativ einfache Herstellung von Verbundfilmen.

Der kathodische Lichtbogen führt zu einer Plasmaentladung innerhalb des von der Kathodenfläche freigesetzten Materialdampfes. Der Lichtbogenpunkt ist normalerweise einige Mikrometer groß und hat Stromdichten von 10 Ampere pro Quadratmikrometer. Diese hohe Stromdichte verursacht eine blitzartige Verdampfung des Ausgangsmaterials. Der erzeugte Dampf besteht aus Elektronen, Ionen, neutralen Dampfatomen und Mikrotröpfchen. Die Elektronen werden gegen die Wolken positiver Ionen beschleunigt. Die Emissionen des Kathodenlichtpunkts sind über einen breiten Bereich des Lichtbogenstromes relativ konstant, wenn der Kathodenpunkt in mehrere Punkte aufgeteilt wird. Der Durchschnittsstrom pro Punkt hängt von der Natur des Kathodenmaterials ab.

Dabei spielt oft auch die Geometrie der Verdampfungsquelle eine wesentliche Rolle. So ist es bekannt sowohl rechteckige als auch zylinderförmige Verdampfungsquellen zu verwenden. Die Auswahl der Geometrie der Verdampfungsquelle kann dabei von einer Vielzahl von Parametern und Randbedingungen der speziellen Beschichtungsanwendung abhängen.

Ein Nachteil der Beschichtungsanlage und des Verfahrens gemäss WO 90/02216 besteht unter anderem darin, dass insbesondere eine gleichbleibende Qualität der Beschichtungen nicht gewährleistet ist. So ändert sich mit zunehmendem Verbrauch der Kathoden die Qualität der aufgebrachten Schichten, wenn nicht die Verfahrensparameter aufwendig nachgeführt werden. Das liegt unter anderem bekanntermassen daran, dass sich die rechteckigen Kathoden ungleichmässig verbrauchen, so dass bei gleichen Verfahrensparametern mit zunehmender Erosion der Kathoden die Qualität des Beschichtungsdampfes zunehmend schlechter wird, was eine Reduktion der Abtragrate zur Folge haben kann, was sich wiederum negativ auf die Schichten auswirken kann. Um diese negativen Effekte in Grenzen zu halten, müssen die Kathoden frühzeitig ausgetauscht werden, was entsprechend teuer und aufwändig ist.

Ein weiterer Nachteil neben der ungleichmässigen Erosion der Kathoden ist, dass eine Steuerung des Lichtbogens auf der Kathode, sofern überhaupt möglich, sehr schwierig und aufwendig ist.

Daher ist es häufig vorteilhafter eine zylindrische Kathode zu verwenden, was bekanntermassen den Vorteil hat, dass die zylindrische Kathode um ihre Zylinderachse drehbar ist und so der Verbrauch des Tragetmaterials besser handhabbar ist. Diese Problematik wurde von der Anmelderin früher bereits eingehend in der EP 2 159 821 diskutiert. Durch Verwendung von Verdampfungsquellen gemäss EP 2 159 821 ändert sich mit zunehmendem Verbrauch der Kathoden die Qualität der aufgebrachten Schichten nicht, und die Verfahrensparameter müssen nicht aufwendig nachgeführt werden. Das liegt unter anderem daran, dass sich die zylindrischen Kathoden gleichmässig verbrauchen, so dass bei gleichen Verfahrensparametern mit zunehmender Erosion der Kathoden die Qualität des Beschichtungsdampfes gleich bleibt. Da bei Verdampfungsquellen gemäss EP 2 159 821 diese negativen Effekte praktisch nicht mehr auftreten, müssen die Kathoden nicht mehr frühzeitig ausgetauscht werden, was zu entsprechenden bedeutenden Kosteneinsparungen führt.

Die EP 2 306 489 A1 beschreibt ein Verfahren zur Beschichtung von Substraten, wobei eine Kathodenanordnung mit einem drehbaren Target vorgesehen ist. Innerhalb des drehbaren Targets ist dabei eine Magnetanordnung positioniert, wobei die gesamte Magnetanordnung bezüglich des drehbaren Targets verschiedene Positionen einnehmen kann.

Die US 4,422,916 A und US 5,922,176 beschreiben Magnetfeldquellen innerhalb eines Targets, beispielsweise Reihen von Permanentmagneten, die fest an einem Trägersystem angeordnet sind, wobei das gesamte Trägersystem beweglich angeordnet ist.

Die JP HO2 4965 A beschreibt Magnetfeldquellen innerhalb eines Targets. Die Magnetfeldquellen sind dabei teilweise fest und teilweise rotierbar an einem Trägersystem angeordnet.

Ein bisher nicht wirklich befriedigend gelöstes Problem zylindrischer Kathoden ist deren häufig mangelnde Flexibilität bezüglich der verwendbaren Verfahren und / oder der für ein bestimmtes Verfahren notwendigen Verfahrensparameter. So besteht mehr und mehr das Bedürfnis, ein und dieselbe Verdampfungsquelle einmal als Zerstäubungskathode, z.B. in einem Sputterverfahren, oder in einem anderen Fall als Lichtbogenverdampfungsquelle in einem kathodischen Lichtbogenverdampfungsverfahren einzusetzen. Selbst dann, wenn eine bestimmte Verdampfungsquelle grundsätzlich nur als Zerstäubungskathode oder grundsätzlich nur als kathodische Lichtbogenverdampfungsquelle verwendet werden soll, so besteht jedoch trotzdem häufig das Bedürfnis, ein und dieselbe Kathode an bestimmte Erfordernisse der Beschichtungsprozesse optimal anzupassen. So ist es möglich, dass sich beispielweise bei Verwendung eines anderen Beschichtungsmaterials auch Prozessparameter wie Prozesskammerdruck, Prozessgase, verwendete elektrische Spannungen und / oder Ströme usw. ändern können, worauf die verwendete Verdampfungsquelle möglichst optimal einstellbar sein soll.

Aufgabe der Erfindung ist es daher, eine verbesserte Verdampfungsquelle, insbesondere zur Verwendung in einem Zerstäubungsverfahren, im Speziellen in einem Sputterverfahren oder einem Vakuumbogenverdampfungsverfahren, insbesondere kathodisches Vakuumbogenverdampfungsverfahren vorzuschlagen, die im Vergleich zum Stand der Technik eine deutlich erhöhte Flexibilität sowohl in Bezug auf die verwendeten Beschichtungsverfahren, als auch in Bezug auf sich ändernde Prozessparameter, wie im Beschichtungsprozess verwendete elektrische Ströme, Spannungen, verwendete Beschichtungsmaterialien, verwendete Prozessgase und andere Verfahrensparameter aufweist. Eine weitere Aufgabe der Erfindung ist es, eine Verdampfungsquelle bereitzustellen, die aufgrund von deutlich flexibleren Anspassungsmöglichkeiten an konkrete Prozesserfordernisse es gestattet, Beschichtungen von höherer Qualität bereitzustellen und die neben einer erhöhten Flexibilität, in der Praxis auch einen effizienteren Gebrauch des Tragetmaterials gestattet, wobei ausserdem eine höhere Lebensdauer der Verdampfungsquelle erreicht werden soll, und wodurch letztlich auch die Kosten der Beschichtungsprozesse reduziert werden können.

Die diese Aufgabe lösenden Gegenstände der Erfindung sind durch die Merkmale des unabhängigen Anspruch 1 gekennzeichnet.

Die abhängigen Ansprüche beziehen sich auf besonders vorteilhafte Ausführungsformen der Erfindung.

Die Erfindung betrifft somit eine zylinderförmige Verdampfungsquelle, die an einer äusseren Zylinderwand ein zu verdampfendes Targetmaterial, sowie eine erste Magnetfeldquelle und eine zweite Magnetfeldquelle umfasst, die zumindest einen Teil eines Magnetsystems bilden und zur Erzeugung eines Magnetfelds in einem Inneren der zylinderförmigen Verdampfungsquelle angeordnet sind. Dabei sind die erste Magnetfeldquelle und die zweite Magnetfeldquelle an einem Trägersystem derart vorgesehen, dass eine Form und / oder eine Stärke des Magnetfeldes in einem vorgebbaren Raumbereich nach einem vorgebbaren Schema einstellbar ist. Erfindungsgemäss ist zur Einstellung der Form und / oder der Stärke des Magnetfeldes das Trägersystem derart ausgestaltet, dass die erste Magnetfeldquelle an einem ersten Trägerarm angeordnet ist und in Bezug auf eine erste Schwenkachse um einen vorgebbaren ersten Schwenkwinkel verschwenkbar ist.

Dadurch, dass zumindest die erste Magnetfeldquelle an einem ersten Trägerarm angeordnet ist und in Bezug auf eine erste Schwenkachse um einen vorgebbaren ersten Schwenkwinkel verschwenkbar ist, so dass das vom Magnetsystem insgesamt erzeugte Magnetfeld in Bezug auf die Magnetfeldstärke und / oder in Bezug auf die vom Magnetsystem erzeugte räumliche Magnetfeldgeometrie ausserordentlich flexibel einstellbar ist, ist es erstmal gelungen, eine Verdampfungsquelle bereitzustellen, die eine bisher nicht bekannte Flexibilität sowohl in Bezug auf die mit der Verdampfungsquelle verwendbaren Beschichtungsverfahren, als auch in Bezug auf die zu verwendenden Prozessparameter aufweist.

Durch die erfindungsgemässe Verdampfungsquelle wird somit das aus dem Stand der Technik bekannte Problem zylindrischer Verdampfungsquellen bezüglich deren mangelnder Anpassungsfähigkeit auf veränderte Prozessbedingungen erstmals befriedigend gelöst. Ein und dieselbe erfindungsgemässe Verdampfungsquelle kann in einer bisher nicht möglichen Flexibilität in ganz unterschiedlichen Beschichtungsverfahren, seien es Zerstäubungsverfahren oder Lichtbogenverdampfungsverfahren verwendet werden, und die Verdampfungsquelle kann extrem flexible auf die für ein bestimmtes Verfahren notwendigen Verfahrensparameter eingestellt werden, wobei eine Anpassung an eine Variationsbreite der unterschiedlichsten Verfahrensparameter in einem Umfang realisierbar ist, wie es mit den aus dem Stand der Technik bekannten Verdampfungsquellen bisher nicht möglich war.

Ein weiterer wesentlicher Vorteil der vorliegenden Erfindung ist es, dass eventuell auf ein zweites Magnetsystem bei einer erfindungsgemässen Verdampfungsquelle verzichtet werden kann, weil durch die grosse Zahl der verfügbaren räumlichen Freiheitsgrade bei der Positionierung des Magnetsystems einer erfindungsgemässen Verdampfungsquelle das Magnetsystem einfach auf die Position eines im Stand der Technik notwendigen zweiten Magnetsystem verschoben werden kann. Es ist in speziellen Fällen sogar möglich, das Magnetfeld von zwei verschiedenen Magnetsystemen mit Hilfe eines einzigen erfindungsgemässen Magnetsystems zu konstruieren, eben weil die einzelnen Komponenten des erfindungsgemässen Magnetsystems sehr flexible einstellbar sind.

Somit wird durch die vorliegende Erfindung das ständig grösser werdende Bedürfnis erstmals in ausreichendem Umfang befriedigt, ein und dieselbe Verdampfungsquelle einmal als Zerstäubungskathode, z.B. in einem Sputterverfahren, oder in einem anderen Fall als Lichtbogenverdampfungsquelle in einem kathodischen oder anodischen Lichtbogenverdampfungsverfahren einzusetzen.

Selbst dann, wenn eine bestimmte erfindungsgemässe Verdampfungsquelle grundsätzlich nur als Zerstäubungskathode oder grundsätzlich nur als anodische oder kathodische Lichtbogenverdampfungsquelle eingesetzt werden soll, kann ein und dieselbe erfindungsgemässe Verdampfungsquelle an bestimmte Erfordernisse der Beschichtungsprozesse optimal angepasst werden. So ist es möglich, dass sich beispielweise bei Verwendung eines anderen Beschichtungsmaterials auch Prozessparameter wie Prozesskammerdruck, Prozessgase, verwendete elektrische Spannungen und / oder Ströme usw. ändern können, worauf die verwendete Verdampfungsquelle problemlos und einfach durch geeignete Justierung des Magnetfeldes eingestellt werden.

Sogar während ein und desselben Beschichtungsprozesses kann eine erfindungsgemässe Verdampfungsquelle äusserst flexibel auf sich ändernde Anforderungen eingestellt werden. So kann z.B. während eines Beschichtungsvorgangs durch die vielfältigen Möglichkeiten der Variation des Magnetfeldes, das vom Magnetsystem erzeugt wird, völlig frei auf neue Prozessparameter reagiert werden. So können in ein und demselben Beschichtungsvorgang komplizierte Schichtsysteme mit variierenden Eigenschaften, beispielsweise mit variierenden chemischen Zusammensetzungen, Härte, Haftfestigkeit, tribologischen Eigenschaften, usw. erzeugt werden, weil die erfindungsgemässe Verdampfungsquelle durch Anpassung der Magnetfeldstärke bzw. der räumlichen Magnetfeldgeometrie nahezu an jede notwendige verfahrenstechnische Randbedingung anpassbar ist.

Bei einem für die Praxis besonders wichtigen Ausführungsbeispiel einer erfindungsgemässen Verdampfungsquelle ist die zweite Magnetfeldquelle an einem zweiten Trägerarm angeordnet und in Bezug auf eine zweite Schwenkachse um einen vorgebbaren zweiten Schwenkwinkel ebenfalls verschwenkbar.

Dabei kann das Magnetsystem besonders vorteilhaft zusätzlich ein erstes magnetisches Element und / oder zusätzlich ein zweites magnetisches Element umfassen, wobei die erste Magnetfeldquelle und / oder die zweite Magnetfeldquelle und / oder das erste magnetische Element und / oder das zweite magnetische Element und / oder das Trägersystem in einer vorgebbaren Raumrichtung linear verschiebbar ausgestaltet sein kann.

Ganz besonders bevorzugt ist dabei die erste Magnetfeldquelle und / oder die zweite Magnetfeldquelle und / oder das erste magnetische Element und / oder das zweite magnetische Element und / oder das Trägersystem in einer Richtung senkrecht zu einer Längsachse des Trägersystems linear verschiebbar angeordnet, und ist insbesondere gleichzeitig senkrecht zur Längsachse und parallel zu einer Winkelhalbierenden eines Gesamtschwenkwinkels, der sich als Gesamtwinkel zwischen der ersten Magnetfeldquelle und der zweiten Magnetfeldquelle ergibt, linear verschiebbar angeordnet.

Zusätzlich oder alternativ kann bei einer erfindungsgemässen Verdampfungsquelle die erste Magnetfeldquelle und / oder die zweite Magnetfeldquelle und / oder das erste magnetische Element und / oder das zweite magnetische Element und / oder das Trägersystem in einer Richtung parallel zur Längsachse des Trägersystems linear verschiebbar angeordnet sein.

In der Praxis kann bei einer erfindungsgemässen Verdampfungsquelle alternativ oder zusätzlich optional die erste Magnetfeldquelle und / oder die zweite Magnetfeldquelle und / oder das erste magnetische Element und / oder das zweite magnetische Element und / oder das Trägersystem auch um einen vorgebbaren Drehwinkel um eine Drehachse drehbar angeordnet sein, wobei die Drehachse bevorzugt parallel zur Längsachse des Trägersystems ist.

In einem anderen speziellen erfindungsgemässen Ausführungsbeispiel kann weiterhin alternativ oder zusätzlich die erste Magnetfeldquelle und / oder die zweite Magnetfeldquelle und / oder das erste magnetische Element und / oder das zweite magnetische Element und / oder das Trägersystem auch um eine Kippachse verkippbar angeordnet sein.

Somit kann eine erfindungsgemässe Verdampfungsquelle eine Flexibilität bezüglich aller denkbaren räumlichen Freiheitsgrade, also in Bezug auf Verschiebungen, Verkippungen, Verdrehungen und Verschwenkungen, auch aller im Magnetsystem vorhandenen Komponenten untereinander bzw. gegeneinander, aufweisen, die eine Anpassung der Stärke und der räumlichen Geometrie des vom Magnetsystem erzeugten Magnetfeldes an praktisch jede denkbare Prozessparameter Kombination erstmals möglich macht.

Das erste magnetische Element und / oder das zweite magnetische Element können dabei in der Praxis in Bezug auf deren Realisierung und / oder deren Positionierung innerhalb des Magnetsystems sehr unterschiedlich ausgebildet sein.

So kann zum Beispiel das erste magnetische Element und / oder das zweite magnetische Element in Bezug auf die Winkelhalbierende des Gesamtschwenkwinkels in einem vorgebbaren Abstand zur Längsachse des Trägersystems, bevorzugt aber nicht notwendig, an einem Joch, im Speziellen an einem Joch aus einem ferritischen Material angeordnet sein. Und / oder das erste magnetische Element und / oder das zweite magnetische Element kann auch ein Zusatzmagnet oder auch das Joch selbst sein.

Es versteht sich dabei von selbst, dass die erste Magnetfeldquelle und / oder die zweite Magnetfeldquelle und / oder das erste magnetische Element und / oder das zweite magnetische Element ein Permanentmagnet, z.B. vom Neodym-Typ oder vom Samarium-Typ, und / oder ein Ferrit und / oder ein Elektromagnet ist, wobei eine Stärke des Magnetfeldes der ersten Magnetfeldquelle und / oder der zweiten Magnetfeldquelle und / oder des ersten magnetische Elements und / oder des zweiten magnetischen Elements steuerbar oder regelbar ist.

Der Fachmann versteht dabei ohne weiteres, dass je nach Anforderung ein erfindungsgemässes Magnetsystem auch noch weitere Magnetfeldquellen bzw. noch weitere magnetische Elemente umfassen kann, die derart geeignet ausgeführt und angeordnet sein können, dass die Flexibilität der Einstellbarkeit von Magnetfeldstärke bzw. räumlicher Ausgestaltung der Magnetfelder noch weiter verbessert ist.

Dem Fachmann ist dabei unmittelbar klar, dass das Magnetsystem im Prinzip zur Bildung eines Magnetfeldes beliebiger Stärker bzw. beliebiger räumlicher Geometrie geeignet sein kann und zum Beispiel ein balanciertes oder ein unbalanciertes Magnetron bilden kann.

Typische Magnetfeldstärken beim Sputtern liegen dabei zum Beispiel in einem Bereich von 10mT bis 500mT, bevorzugt zwischen 25mT bis 100mT, beispielweise im balancierten oder unbalancierten Betriebsmodus, wobei die absoluten Magnetfeldstärken in der Praxis selbstverständlich räumlich mehr oder weniger stark variieren können und selbstverständlich auch Feldstärken haben können, die deutlich oberhalb oder unterhalb der angegebenen Werte liegen können.

Typische Magnetfeldstärken beim Lichtbogenverdampfen liegen zum Beispiel in einem Bereich von 0.1mT bis 50mT, bevorzugt zwischen 1mT bis 20mT, wobei natürlich auch hier die absoluten Magnetfeldstärken in der Praxis selbstverständlich räumlich mehr oder weniger stark variieren können und natürlich auch Feldstärken haben können, die deutlich oberhalb oder unterhalb der angegebenen Werte liegen können.

Dabei kann, wie bereits mehrfach erwähnt, eine erfindungsgemässe Verdampfungsquelle derart als Verdampfungskathode oder Verdampfungsanode ausgestaltet ist, dass die Verdampfungskathode sowohl als Zerstäubungskathode, als auch als Lichtbogenverdampfungsquelle, insbesondere als Lichtbogenkathode verwendbar ist.

Es versteht sich, dass in der Praxis bei einer erfindungsgemässen Verdampfungsquelle notwendige, dem Fachmann an sich bekannte weitere Komponenten vorgesehen werden können. Insbesondere kann z.B. ein an sich bekanntes Kühlsystem vorhanden sein, wie es dem Fachmann aus dem Stand der Technik an sich bekannt ist, wobei die Verdampfungsquelle aufgrund ihres Aufbaus oft auch ganz auf ein zusätzliches Kühlsystem verzichten kann, was im Speziellen ein weiterer Vorteil der vorliegenden Erfindung sein kann.

Die Erfindung wird im Folgenden an Hand der schematischen Zeichnung näher erläutert. Es zeigen:
- Fig. 1a: ein erstes einfaches Ausführungsbeispiel einer erfindungsgemässen Verdampfungsquelle in perspektivischer Darstellung;
- Fig. 1b: die Verdampfungsquelle der Fig. 1a mit stark gegeneinander verschwenkten Magnetfeldquellen;
- Fig. 1c: das Magnetsystem der Verdampfungsquelle der Fig. 1a in perspektivischer Ansicht;
- Fig. 2a: eine Draufsicht auf ein zweites Ausführungsbeispiel einer erfindungsgemässen Verdampfungsquelle mit zwei zusätzlichen magnetischen Elementen;
- Fig. 2b: die Verdampfungsquelle der Fig. 2a, wobei das zweite magnetische Elemente in Form eines ferritschen Jochs ausgebildet ist;
- Fig. 3: ein drittes Ausführungsbeispiel mit einer verkippbaren Magnetfeldquelle;
- Fig. 4a: ein viertes Ausführungsbeispiel in Form einer Sputterquelle, eingestellt als stark balanciertes Magnetron;
- Fig. 4b: das Ausführungsbeispiel der Fig. 4a eingestellt als balanciertes Magnetron;
- Fig. 4c: das Ausführungsbeispiel der Fig. 4a eingestellt als unbalanciertes Magnetron;
- Fig. 5a: das Ausführungsbeispiel der Fig. 4a in Form einer Lichtbogenverdampfungsquelle;
- Fig. 5b: das Ausführungsbeispiel der Fig. 5a zur Nutzung des Lichtbogens auf der gegenüberliegenden Seite.

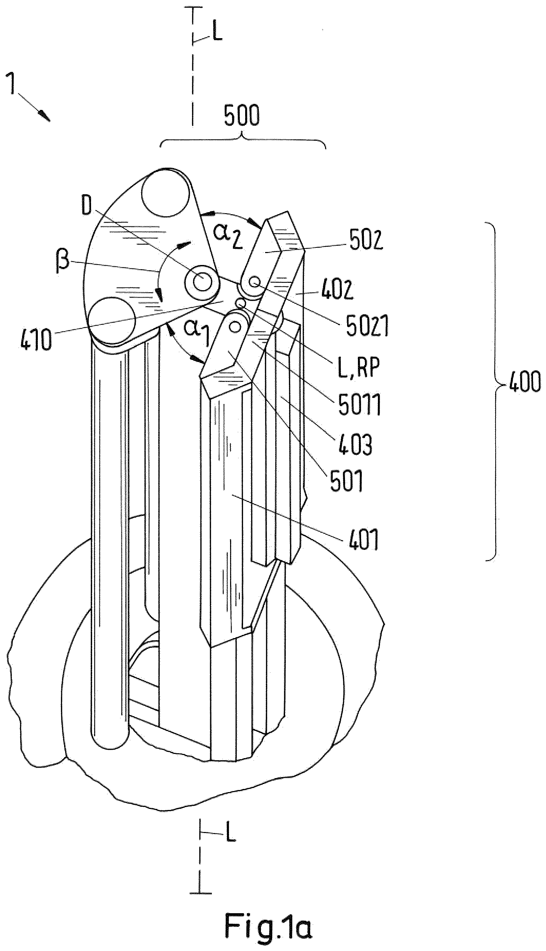

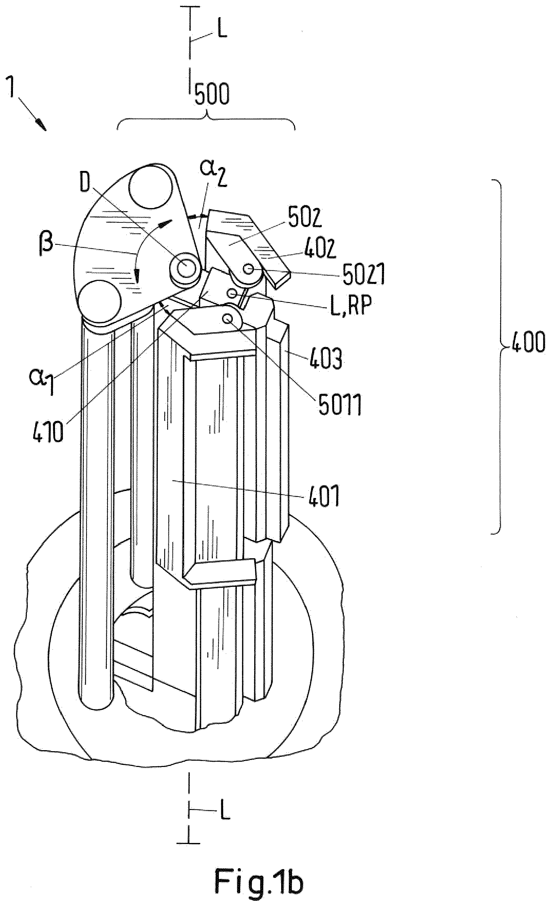

Fig. 1a zeigt in einer schematischen Darstellung ein erstes einfaches Ausführungsbeispiel einer erfindungsgemässen Verdampfungsquelle in perspektivischer Darstellung, wobei eine erfindungsgemässe Verdampfungsquelle im Folgenden gesamthaft mit dem Bezugszeichen 1 bezeichnet wird. Die Fig. 1b zeigt dabei die Verdampfungsquelle 1 der Fig. 1a mit stark gegeneinander verschwenkten Magnetfeldquellen 401, 402.

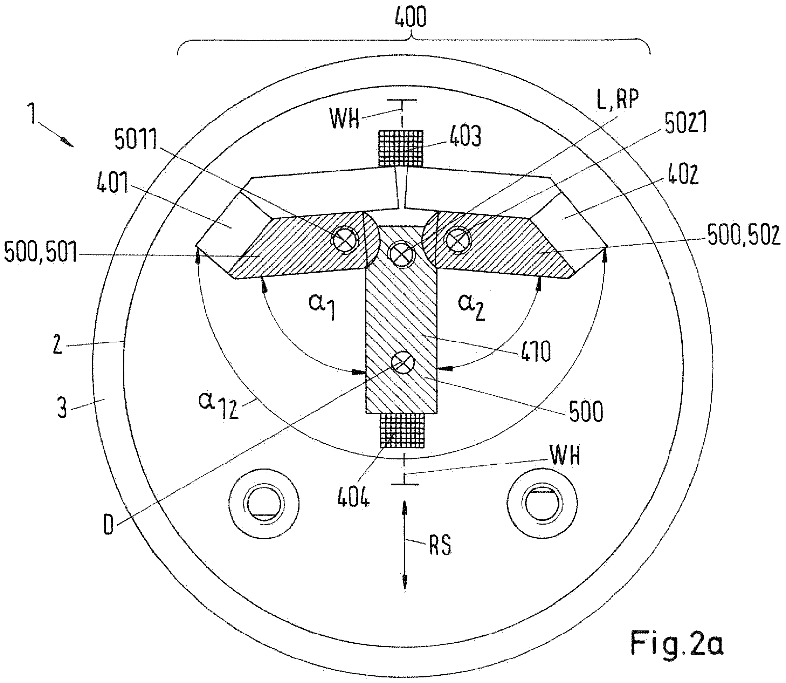

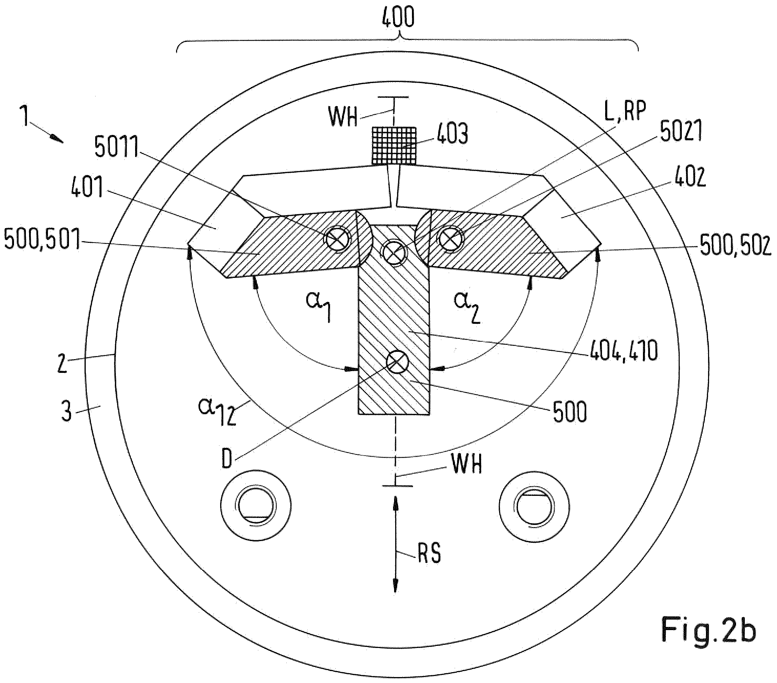

Die erfindungsgemässe Verdampfungsquelle 1 gemäss Fig. 1a bzw. Fig. 1b ist insbesondere zur Verwendung in einem Sputterverfahren oder einem Vakuumbogenverdampfungsverfahren, bevorzugt zur Verwendung in einem kathodisches Vakuumbogenverdampfungsverfahren konzipiert. Die zylinderförmige Verdampfungsquelle 1, ist von einer aus Gründen der Übersichtlichkeit in Fig. 1a bzw. Fig. 1b nicht dargestellten äusseren Zylinderwand 2 umfassend ein zu verdampfendes Targetmaterial 3 umgeben, wie es für ein analoges Ausführungsbeispiel z.B. anhand der Fig. 2a und Fig. 2b deutlich dargestellt ist und aus dem Stand der Technik an sich bekannt ist.

Die erfindungsgemässe Verdampfungsquelle 1 umfasst weiter als zentrale Komponenten eine erste stabartige Magnetfeldquelle 401 und eine zweite stabartige Magnetfeldquelle 402, die sich jeweils in Längsrichtung L erstrecken, wobei die Magnetfeldquellen 401, 402 einen Teil eines gesamten Magnetsystems 400 bilden und zur Erzeugung eines Magnetfelds in einem Inneren der zylinderförmigen Verdampfungsquelle 1 wie beschrieben parallel zur Längsrichtung L angeordnet sind. Dabei sind die erste Magnetfeldquelle 401 und die zweite Magnetfeldquelle 402 an einem Trägersystem 500 derart vorgesehen, dass eine Form und / oder eine Stärke des Magnetfeldes in einem vorgebbaren Raumbereich nach einem vorgebbaren Schema einstellbar ist. Gemäss der vorliegenden Erfindung ist zur Einstellung der Form und / oder der Stärke des Magnetfeldes das Trägersystem 500 derart ausgestaltet ist, dass die erste Magnetfeldquelle 401 an einem ersten beweglichen Trägerarm 501 angeordnet und in Bezug auf eine erste Schwenkachse 5011 um einen vorgebbaren ersten Schwenkwinkel α₁ verschwenkbar ist. Ebenso ist die zweite Magnetfeldquelle 402 an einem zweiten beweglichen Trägerarm 502 angeordnet und ist in Bezug auf eine zweite Schwenkachse 5021 um einen vorgebbaren zweiten Schwenkwinkel α₂ verschwenkbar.

Zusätzlich umfasst das Magnetsystem 400 noch ein erstes magnetisches Element 403, das zwischen den beiden stabartigen Magnetfeldquellen 401, 402 in Längsrichtung ebenfalls am Trägersystem angeordnet ist.

Im vorliegenden speziellen Ausführungsbeispiel der Fig. 1a bzw. Fig. 1b ist die erste Magnetfeldquelle 401, die zweite Magnetfeldquelle 402, und das erste magnetische Element 403 jeweils ein Stabmagnet. In einem analogen Ausführungsbeispiel können die erste Magnetfeldquelle 401, oder die zweite Magnetfeldquelle 402, oder das erste magnetische Element 403 auch durch eine Mehrzahl von jeweils in Längsrichtung angeordneten einzelnen Permanentmagneten ausgebildet sein, was im Prinzip auch aus dem Stand der Technik an sich bekannt ist. Dabei versteht es sich von selbst, dass die erste Magnetfeldquelle 401 oder die zweite Magnetfeldquelle 402 oder das erste magnetische Element 403 auch einen ein Ferrit umfassen können oder durch einen Elektromagnet gebildet sein oder durch ein anderes an sich bekanntes magnetisches Element realisiert sein.

Wie der Fig. 1a bzw. Fig. 1b, sowie den Fig. 2a und Fig. 2b sehr deutlich zu entnehmen ist, hat das ferritische Joch 410 der Mittelmagnetreihe bogenförmige Anpassungen, die die Geometrie des Schwenkflügels 501, 502 in sich projizieren lässt, so dass in einem weiten Winkelbereich α₁, α₂ ein möglichst optimaler magnetischer Schluss während der gesamten Schwenkbewegung zwischen den Magnetfeldquellen 401, 402, und / oder den Trägerarmen 501, 502 und dem Joch 410 bei der gesamten Schwenkbewegung um die Schwenkachsen 5011, 5021 gewährleistet ist.

Die erste Magnetfeldquelle 401 und / oder die zweite Magnetfeldquelle 402 und / oder das erste magnetische Element 403 und / oder das zweite magnetische Element 404 und / oder das Trägersystem 500 sind dabei um einen vorgebbaren Drehwinkel β um eine Drehachse D drehbar angeordnet, wobei die Drehachse D bevorzugt parallel zur Längsachse L des Trägersystems 500 ist. Die Drehung um den Drehwinkel β kann dabei mehrere Funktionen erfüllen. Durch Drehen um den Drehwinkel β kann das gesamte Magnetsystem 400 zum Beispiel relativ zu einem zu beschichtenden Substrat eingestellt werden. Ausserdem kann natürlich auch eine relative Lage zu einer zweiten Verdampfungsquelle, sofern vorhanden, eingestellt werden. Selbstverständlich kann durch eine Drehung von ca. 180° um den Drehwinkel β das Magnetsystem 400 quasi umgeklappt werden, was zum Beispiel mit Bezug auf das erste magnetische Element 403 vorteilhaft dazu genutzt werden kann, die Oberfläche an einem vorgebbaren Bereich frei zu sputtern.

Die Fig. 1b unterscheidet sich von der Fig. 1a dabei nur dadurch, dass die erste Magnetfeldquelle 401 und die zweite Magnetfeldquelle 402 in Fig. 1b fast maximal, sehr stark gegeneinander verschwenkt sind, während im Beispiel der Fig. 1a die erste Magnetfeldquelle 401 und die zweite Magnetfeldquelle 402 nicht miteinander verschwenkt sind, sondern einen miteinander einen gestreckten Winkel von insgesamt 180° bilden.

Zusätzlich ist das Trägersystem 500 noch um den Drehwinkel b um die Drehachse D verdrehbar, so dass das Targetmaterial 3 auf der in Fig. 1a bzw. Fig. 1b nicht dargestellten Zylinderwand durch Drehen des Trägersystems 500 und damit durch Drehen des Magnetsystems 400 nacheinander von unterschiedlichen Bereichen der Oberfläche der Zylinderwand 2 verdampfbar ist.

In dem Zusammenhang ist es z.B. möglich, dass nach und nach verschiedene Bereich der Oberfläche verdampft werden, so dass z.B. ein gleichmässigerer Abtrag des Targetmaterials 3 erfolgt und / oder die Lebensdauer der Verdampfungsquelle erhöht wird und / oder eine Beschichtungsqualität einer durch den Verdampfungsprozess aufzubringenden Beschichtung auf einem Substrat verbessert wird. Auch kann die z.B. das Magnetsystem in einer oszillierenden Bewegung um die Drehachse D abwechseln hin und her verschwenkt werden oder das Targetmaterial 3 kann in anderer geeigneter Weise in einem vorteilhaften Verfahren von der Oberfläche der Zylinderwand 2 verdampft werden.

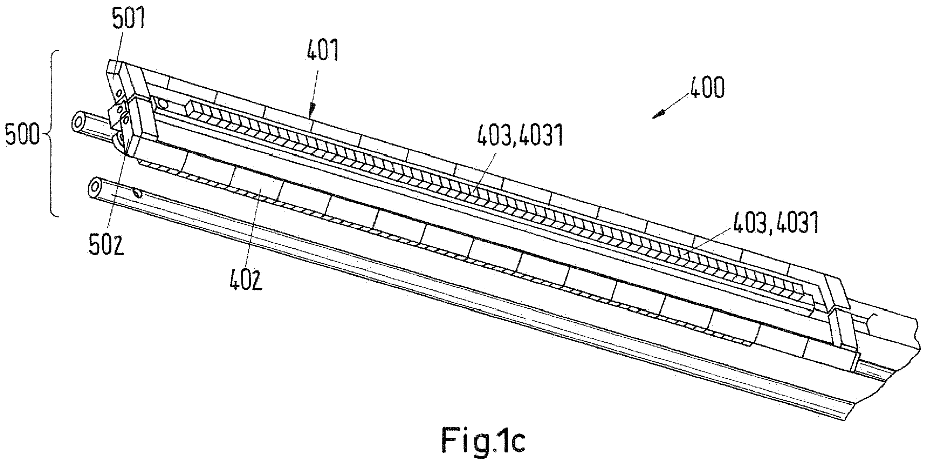

Fig. 1c zeigt zur Verdeutlichung das Magnetsystem 400 der Verdampfungsquelle 1 der Fig. 1a nochmals in einer perspektivischen Ansicht, die die gegenseitige Anordnung von erster Magnetfeldquelle 401, zweiter Magnetfeldquelle 402, und erstem magnetischem Element 403 noch besser verdeutlicht. Deutlich zu erkennen ist, dass bei diesem speziellen Ausführungsbeispiel das magnetische Element 403 aus einer Vielzahl von einzelnen, aneinander gereihten einzelnen Permanentmagneten 4031 bebildet ist.

Fig. 2a zeigt eine Draufsicht auf ein zweites Ausführungsbeispiel einer erfindungsgemässen Verdampfungsquelle 1 mit zwei zusätzlichen magnetischen Elementen 403, 404, wobei sich das Ausführungsbeispiel der Fig. 2b von der Verdampfungsquelle der Fig. 2a dadurch unterscheidet, dass das zweite magnetische Element 404 in Form eines ferritischen Jochs 410 ausgebildet ist, so dass kein zusätzlicher Magnet 404 notwendig ist, wie das bei dem Ausführungsbeispiel der Fig. 2a noch der Fall ist.

Bei der zylinderförmigen Verdampfungsquelle 1 mit äusserer Zylinderwand 2, auf dem ein zu verdampfendes Targetmaterial 3 bereitgestellt ist, sind die erste Magnetfeldquelle 401 und die zweite Magnetfeldquelle 402 jeweils um den ersten Schwenkwinkel α₁ in Bezug auf die erste Schwenkachse 5011, bzw. um den zweiten Schwenkwinkel α₂ in Bezug auf die zweite Schwenkachse 5021 gegeneinander verschwenkt, wobei im vorliegenden Ausführungsbeispiel die beiden Schwenkwinkel α₁ und α₂ gleich sind. D.h., dass die erste Magnetfeldquelle 401 und die zweite Magnetfeldquelle 402 in Bezug auf die Winkelhalbierende WH symmetrisch gegeneinander verschwenkt sind. Es versteht sich von selbst, dass in einem anderen Ausführungsbeispiel die erste Magnetfeldquelle 401 und die zweite Magnetfeldquelle 402 auch asymmetrisch gegeneinander verschwenkt sein können, die beiden Schwenkwinkel α₁ und α₂ also nicht zwingend gleich sein müssen. Typische Grössen für die Schwenkwinkel α₁ und α₂ liegen im Bereich zwischen 0° und ca. 130°, d.h. die Winkel α₁ und α₂ können natürlich auch Werte grösser als 90° einnehmen. Bevorzugte Schwenkwinkel liegen dabei z.B. zwischen ca. 60° und 110° und können natürlich auch ganz andere Werte annehmen, als die zuvor lediglich exemplarisch erwähnten Winkelgrössen.

Wie durch den Doppelpfeil RS angedeutet wird, lässt sich das Magnetsystem 400 in den vorliegenden Ausführungsbeispielen der Fig. 2a und Fig. 2b zur Veränderung der Magnetfeldstärke und / oder der räumlichen Geometrie des durch das Magnetsystem 400 erzeugten Magnetfeldes in der Richtung RS senkrecht zu einer Längsachse L des Trägersystems 500 linear verschieben, insbesondere gleichzeitig senkrecht zur Längsachse L und parallel zur Winkelhalbierenden WH des Gesamtschwenkwinkels α₁₂ linear verschiebbar.

Die Verschiebung entlang der Richtung RS kann dabei verschiedene Funktionen erfüllen. Sie kann zum Beispiel dazu dienen, die Magnetfeldstärke des ersten magnetischen Elements 403 in Bezug auf die Verdampferoberfläche von einem sehr hohen Wert, wenn sich das erste magnetische Element 403 nahe der Oberfläche befindet, auf einen niedrigeren Wert, wenn sich das erste magnetische Element 403 weiter weg von der Oberfläche befindet, einzustellen, beispielweise um von einem Magnetron-Mode auf einen Arc-Mode zu wechseln. Darüber hinaus kann durch eine Verschiebung entlang der Richtung RS auch die Magnetfeldstärke mit abnehmender Targetdicke an der Verdampferoberfläche konstant gehalten werden. Schliesslich kann eine Verschiebung entlang der Richtung RS auch dazu genutzt werden, das zweite magnetische Element 404 in Richtung zur hinteren Funktionsoberfläche der Verdampferquelle 1 zu verschieben.

Die Bewegung des Trägersystems bzw. einzelner Komponenten des Trägersystems kann dabei mit an sich bekannten einfachen mechanischen Einrichtungen und Massnahmen erfolgen. So kann beispielsweise die lineare Bewegung und / oder die Kipp-, Schwenk-, oder Drehbewegung des Magnetsystems 400 oder einzelner Komponenten allein, wie zum Beispiel die Bewegung des Jochs 410 über geeignet vorgesehene Gewindespindeln, eventuell in Verbindung mit einem Kettenantrieb erfolgen. Dabei kann der Antrieb selbstverständlich einfach durch einen Bediener von Hand erfolgen, aber es können auch geeignet Stellmotoren vorgesehen werden, so dass der Antrieb elektrisch, im Speziellen sogar vollautomatisch mittels einer Computersteuerung erfolgen kann.

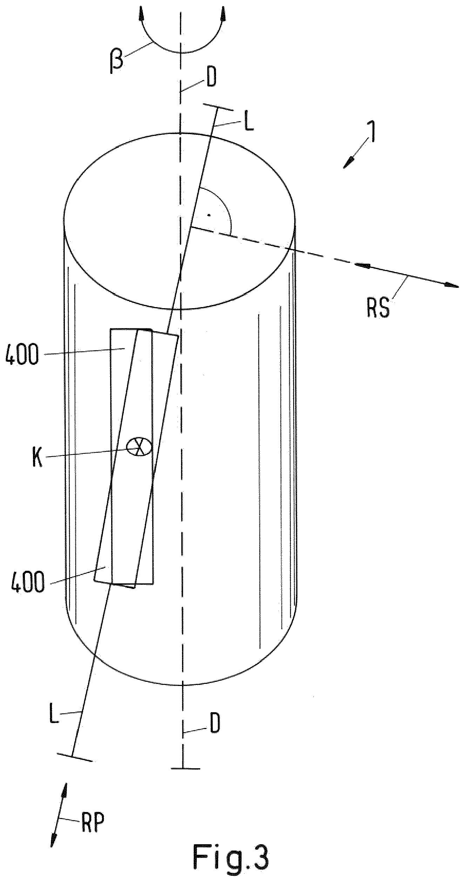

Dabei kann, wie bereits erwähnt, das Magnetsystem 400 auch über eine Kippbewegung in Bezug auf die Längsachse L justiert werden, wie anhand der Fig. 3 an einem dritten Ausführungsbeispiel in einer stark schematisierten Zeichnung erläutert wird.

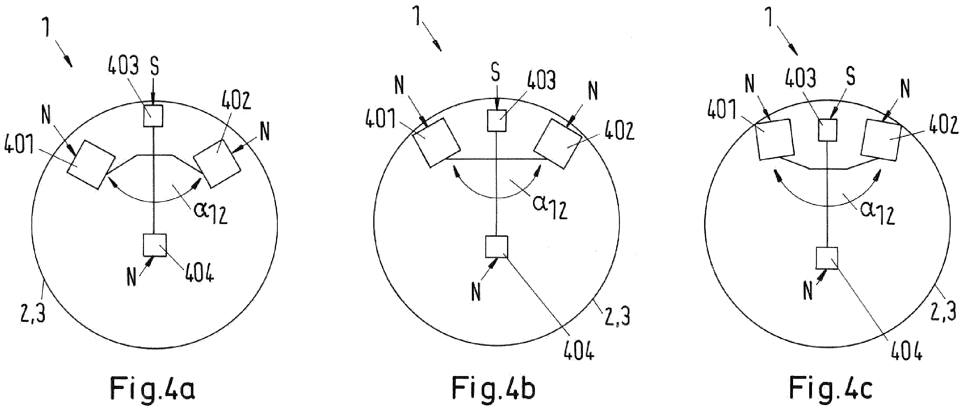

Anhand der Fig. 4a bis Fig. 4c ist ein viertes Ausführungsbeispiel einer erfindungsgemässen Verdampfungsquelle 1 stark schematisch dargestellt. Fig. 4a, Fig. 4b, und Fig. 4c zeigen dabei ein und dieselbe Verdampfungsquelle 1, die jedoch in den drei Abbildungen in drei verschiedenen Betriebsarten als Sputterquellen gezeigt sind, was die enorme Flexibilität der erfindungsgemässen Verdampfungsquelle 1 eindrucksvoll demonstriert.

Fig. 4a zeigt ein Ausführungsbeispiel in Form einer Sputterquelle, wobei die einzelnen magnetischen Komponenten so gewählt sind und das Magnetsystem 400 derart auf einen Gesamtschwenkwinkel α₁₂ kleiner als 180°eingestellt ist, dass das Magnetsystem im Betriebsmodus eines balancierten Magnetrons arbeitet.

Bei Fig. 4b wurde der Gesamtschwenkwinkel α₁₂ der Sputterquelle aus Fig. 4a zu ca. 180° gewählt, was dazu führt, dass das Ausführungsbeispiel der Fig. 4b nunmehr im Betriebsmodus eines stark balancierten Magnetrons arbeitet.

Bei Fig. 4c wurde der Gesamtschwenkwinkel α₁₂ der Sputterquelle aus Fig. 4a grösser als 180° gewählt, so dass die Sputterquelle hier im Betriebsmodus eines unbalancierten Magnetrons arbeitet.

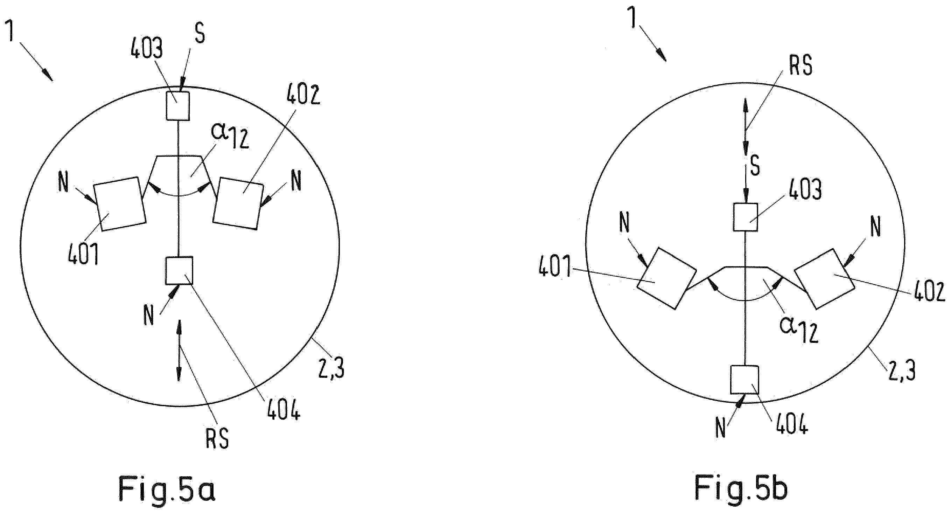

Wie die Fig. 5a und 5b zeigen, kann die Verdampfungsquelle 1 der Fig. 4a aber auch als Lichtbogenverdampfungsquelle eingestellt werden. Das wird insbesondere in Fig. 5a dadurch erreicht, dass der Gesamtschwenkwinkel α₁₂ der Sputterquelle aus Fig. 5a viel kleiner als 180° gewählt wird. Bei Fig. 5b wurde das Magnetsystem 400 linear in Richtung zur darstellungsgemäss gegenüberliegenden Seite verschoben. Dadurch kann die Verdampfungsquelle 1 immer noch als Lichtbogenverdampfungsquelle betrieben werden, allerdings wird jetzt das Targetmaterial 3 auf der gegenüberliegenden Seite der Verdampfungsquelle 1 frei ge-arct oder frei gesputtert, wobei in an sich bekannter Weise ein Shutter, z.B. ein rohrförmiger Shutter mit entsprechenden Aussparungen vorgesehen sein kann, so dass je nach Bedarf das erste magnetische Element 403 oder das zweite magnetische Element 404 abdeckbar ist. Durch diese oder andere an sich bekannte Massnahmen ist insbesondere ein gleichmässigerer Materialabtrag und damit insbesondere eine höhere Lebensdauer der Verdampfungsquelle 1 erreichbar ist.

Es versteht sich von selbst, dass der konkrete Betriebsmodus in dem die erfindungsgemässe Verdampfungsquelle 1 betrieben werden kann nicht allein davon abhängt, ob der Gesamtschwenkwinkel α₁₂ zwischen der ersten Magnetfeldquelle 401 und der zweiten Magnetfeldquelle 402 grösser oder kleiner als 180°, oder gleich 180° ist. Vielmehr haben im konkreten Fall selbstverständlich auch andere Parameter, wie die magnetische Stärke der einzelnen Komponenten des Magnetsystems, deren Abstand zueinander usw. ebenfalls einen erheblichen Einfluss auf den Betriebsmodus, was der Fachmann ohne weiteres weiss und natürlich auch weiss, wie die Gesamtgeometrie des Magnetsystems 400 einzustellen ist, um den gewünschten Betriebsmodus zu erhalten.

Durch die vorliegende Erfindung wird somit erstmals eine wesentlich verbesserte Verdampfungsquelle, insbesondere zur Verwendung in einem Zerstäubungsverfahren, im Speziellen in einem Sputterverfahren oder einem Vakuumbogenverdampfungsverfahren, insbesondere kathodisches oder anodisches Vakuumbogenverdampfungsverfahren bereitgestellt, die im Vergleich zum Stand der Technik eine deutlich erhöhte Flexibilität sowohl in Bezug auf die verwendeten Beschichtungsverfahren, als auch in Bezug auf sich ändernde Prozessparameter, wie z.B. im Beschichtungsprozess verwendete elektrische Ströme, Spannungen, verwendete Beschichtungsmaterialien, verwendete Prozessgase und andere Verfahrensparameter aufweist. Ausserdem gestattet es die erfindungsgemässe Verdampfungsquelle aufgrund der deutlich flexibleren Anspassungsmöglichkeiten an konkrete Prozesserfordernisse, Beschichtungen von höchster Qualität bereitzustellen, erlaubt in der Praxis auch einen effizienteren Gebrauch des Tragetmaterials, wobei ausserdem eine höhere Lebensdauer der Verdampfungsquelle erreicht wird, und somit letztlich auch die Kosten der Beschichtungsprozesse merklich reduziert werden.

Es versteht sich dabei von selbst, dass die zuvor erläuterten und in den Abbildungen schematisch dargestellten Ausführungsvarianten auch vorteilhaft miteinander zu weiteren Ausführungsbeispielen kombinierbar sind, um speziellen Anforderungen in der Praxis gerecht zu werden. Darüber hinaus sind selbstverständlich auch einfache, dem Fachmann naheliegende Weiterbildungen von der Erfindung erfasst.

## Patentansprüche

1. Zylinderförmige Verdampfungsquelle, die an einer äusseren Zylinderwand (2) ein zu verdampfendes Targetmaterial (3), eine erste Magnetfeldquelle (401), eine zweite Magnetfeldquelle (402) und eine Drehachse (D) umfasst, wobei die erste Magnetfeldquelle (401) und die zweite Magnetfeldquelle (402) zumindest einen Teil eines Magnetsystems (400) bilden und zur Erzeugung eines Magnetfelds in einem Inneren der zylinderförmigen Verdampfungsquelle angeordnet sind, und die erste Magnetfeldquelle (401) und die zweite Magnetfeldquelle (402) an einem Trägersystem (500) derart vorgesehen sind, dass eine Form und / oder eine Stärke des Magnetfeldes in einem vorgebbaren Raumbereich nach einem vorgebbaren Schema einstellbar ist, und zur Einstellung der Form und / oder der Stärke des Magnetfeldes das Trägersystem (500) derart ausgestaltet ist, dass die erste Magnetfeldquelle (401) an einem ersten Trägerarm (501) angeordnet ist und in Bezug auf eine erste Schwenkachse (5011) um einen vorgebbaren ersten Schwenkwinkel (α₁) verschwenkbar ist, wobei die erste Magnetfeldquelle (401) und die zweite Magnetfeldquelle (402) gegeneinander verschwenkbar sind, **dadurch gekennzeichnet, dass** die erste Schwenkachse (5011) und die Drehachse (D) voneinander verschieden sind.

2. Verdampfungsquelle nach Anspruch 1, wobei die zweite Magnetfeldquelle (402) an einem zweiten Trägerarm (502) angeordnet ist und in Bezug auf eine zweite Schwenkachse (5021) um einen vorgebbaren zweiten Schwenkwinkel (α₂) verschwenkbar ist.

3. Verdampfungsquelle nach einem der Ansprüche 1 oder 2, wobei das Magnetsystem (400) zusätzlich ein erstes magnetisches Element (403) umfasst.

4. Verdampfungsquelle nach einem der vorangehenden Ansprüche, wobei das Magnetsystem (400) zusätzlich ein zweites magnetisches Element (404) umfasst.

5. Verdampfungsquelle nach einem der vorangehenden Ansprüche, wobei die erste Magnetfeldquelle (401) und / oder die zweite Magnetfeldquelle (402) und / oder das erste magnetische Element (403) und / oder das zweite magnetische Element (404) und / oder das Trägersystem (500) in einer vorgebbaren Raumrichtung linear verschiebbar ist.

6. Verdampfungsquelle nach einem der vorangehenden Ansprüche, wobei die erste Magnetfeldquelle (401) und / oder die zweite Magnetfeldquelle (402) und / oder das erste magnetische Element (403) und / oder das zweite magnetische Element (404) und / oder das Trägersystem (500) in einer Richtung (RS) senkrecht zu einer Längsachse (L) des Trägersystems (500) linear verschiebbar angeordnet ist, insbesondere gleichzeitig senkrecht zur Längsachse (L) und parallel zu einer Winkelhalbierenden (WH) eines Gesamtschwenkwinkels (α₁₂) linear verschiebbar angeordnet ist.

7. Verdampfungsquelle nach einem der vorangehenden Ansprüche, wobei die erste Magnetfeldquelle (401) und / oder die zweite Magnetfeldquelle (402) und / oder das erste magnetische Element (403) und / oder das zweite magnetische Element (404) und / oder das Trägersystem (500) in einer Richtung (RP) parallel zur Längsachse (L) des Trägersystems (500) linear verschiebbar angeordnet ist.

8. Verdampfungsquelle nach einem der vorangehenden Ansprüche, wobei die erste Magnetfeldquelle (401) und / oder die zweite Magnetfeldquelle (402) und / oder das erste magnetische Element (403) und / oder das zweite magnetische Element (404) und / oder das Trägersystem (500) um einen vorgebbaren Drehwinkel (β) um eine Drehachse (D) drehbar angeordnet ist, wobei die Drehachse (D) bevorzugt parallel zur Längsachse (L) des Trägersystems (500) ist.

9. Verdampfungsquelle nach einem der vorangehenden Ansprüche, wobei die erste Magnetfeldquelle (401) und / oder die zweite Magnetfeldquelle (402) und / oder das erste magnetische Element (403) und / oder das zweite magnetische Element (404) und / oder das Trägersystem (500) um eine Kippachse (K) verkippbar angeordnet ist.

10. Verdampfungsquelle nach einem der Ansprüche 3 bis 9, wobei das erste magnetische Element (403) und / oder das zweite magnetische Element (404) in Bezug auf die Winkelhalbierende (WH) des Gesamtschwenkwinkels (α₁₂) in einem vorgebbaren Abstand zur Längsachse (L) des Trägersystems (500), bevorzugt an einem Joch (410), im Speziellen an einem Joch (410) aus einem ferritischen Material angeordnet ist.

11. Verdampfungsquelle nach einem der Ansprüche 3 bis 10, wobei das erste magnetische Element (403) und / oder das zweite magnetische Element (404) ein Zusatzmagnet ist oder das Joch (410) ist.

12. Verdampfungsquelle nach einem der vorangehenden Ansprüche, wobei die erste Magnetfeldquelle (401) und / oder die zweite Magnetfeldquelle (402) und / oder das erste magnetische Element (403) und / oder das zweite magnetische Element (404) ein Permanentmagnet und / oder ein Ferrit und / oder ein Elektromagnet ist.

13. Verdampfungsquelle nach einem der vorangehenden Ansprüche, wobei eine Stärke des Magnetfeldes der ersten Magnetfeldquelle (401) und / oder der zweiten Magnetfeldquelle (402) und / oder des ersten magnetische Elements (403) und / oder des zweiten magnetischen Elements (404) steuerbar oder regelbar ist.

14. Verdampfungsquelle nach einem der vorangehenden Ansprüche, wobei das Magnetsystem (400) ein balanciertes oder ein unbalanciertes Magnetron bildet.

15. Verdampfungsquelle nach einem der vorangehenden Ansprüche, wobei die Verdampfungsquelle derart als Verdampfungskathode oder Verdampfungsanode ausgestaltet ist, dass die Verdampfungskathode sowohl als Zerstäubungskathode, als auch als Lichtbogenverdampfungsquelle, insbesondere als Lichtbogenkathode verwendbar ist.

## Claims

1. A cylindrical evaporation source, which comprises a target material (3) to be vaporized, a first magnetic field source (401), a second magnetic field source (402) and an axis of rotation (D) on an outer cylinder wall (2), the first magnetic field source (401) and the second magnetic field source (402) forming at least a part of a magnetic system (400) and being arranged inside the cylindrical evaporation source for generating a magnetic field, and the first magnetic field source (401) and the second magnetic field source (402) being provided at a support system (500) in such a way that a form and / or a strength of the magnetic field can be adjusted in a predeterminable region of the room according to a predeterminable scheme, and the support system (500) is designed in such a way for adjusting the form and / or the strength of the magnetic field that the first magnetic field source (401) is arranged at a first supporting arm (501) and is pivotable with respect to a first pivot axis (5011) about a predeterminable first pivot angle (α₁), wherein the first magnetic field source (401) and the second magnetic field source (402) are pivotable relative to each other, **characterized in that** the first pivot axis (5011) and the axis of rotation (D) are different from each other.

2. An evaporation source according to claim 1, wherein the second magnetic field source (402) is arranged at a second supporting arm (502) and is pivotable with respect to a second pivot axis (5021) about a predeterminable second pivot angle (α₂).

3. An evaporation source according to anyone of the claims 1 or 2, wherein the magnetic system (400) additionally comprises a first magnetic element (403).

4. An evaporation source according to anyone of the preceding claims, wherein the magnetic system (400) additionally comprises a second magnetic element (404).

5. An evaporation source according to anyone of the preceding claims, wherein the first magnetic field source (401) and / or the second magnetic field source (402) and / or the first magnetic element (403) and / or the second magnetic element (404) and / or the support system (500) can be linearly displaced in a predeterminable spatial direction.

6. An evaporation source according to anyone of the preceding claims, wherein the first magnetic field source (401) and / or the second magnetic field source (402) and / or the first magnetic element (403) and / or the second magnetic element (404) and / or the support system (500) is arranged linearly displaceable in a direction (RS) perpendicular to a longitudinal axis (L) of the support system (500), in particular arranged linearly displaceable simultaneously perpendicular to the longitudinal axis (L) and parallel to an angle bisector (WH) of a total pivot angle (α₁₂).

7. An evaporation source according to anyone of the preceding claims, wherein the first magnetic field source (401) and / or the second magnetic field source (402) and / or the first magnetic element (403) and / or the second magnetic element (404) and / or the support system (500) is arranged linearly displaceable in a direction (RP) parallel to the longitudinal axis (L) of the support system (500).

8. An evaporation source according to anyone of the preceding claims, wherein the first magnetic field source (401) and / or the second magnetic field source (402) and / or the first magnetic element (403) and / or the second magnetic element (404) and / or the support system (500) is arranged rotatable about an axis of rotation (D) by a predeterminable angle of rotation (β), wherein the axis of rotation (D) is preferably parallel to the longitudinal axis (L) of the support system (500).

9. An evaporation source according to anyone of the preceding claims, wherein the first magnetic field source (401) and / or the second magnetic field source (402) and / or the first magnetic element (403) and / or the second magnetic element (404) and / or the support system (500) is arranged that it can be tilted about a tilting axis (K).

10. An evaporation source according to anyone of the claims 3 to 9, wherein the first magnetic element (403) and / or the second magnetic element (404) is preferably arranged on a yoke (410), in particular on a yoke (410) made of a ferritic material at a predeterminable distance from the longitudinal axis (L) of the support system (500) with respect to the angle bisector (WH) of the total pivot angle (α₁₂).

11. An evaporation source according to anyone of the claims 3 to 10, wherein the first magnetic element (403) and / or the second magnetic element (404) is an additional magnet or the yoke (410).

12. An evaporation source according to anyone of the preceding claims, wherein the first magnetic field source (401) and / or the second magnetic field source (402) and / or the first magnetic element (403) and / or the second magnetic element (404) is a permanent magnet and / or a ferrite and / or an electromagnet.

13. An evaporation source according to anyone of the preceding claims, wherein a strength of the magnetic field of the first magnetic field source (401) and / or of the second magnetic field source (402) and / or of the first magnetic element (403) and / or of the second magnetic element (404) can be controlled or adjusted.

14. An evaporation source according to anyone of the preceding claims, wherein the magnetic system (400) forms a balanced or an unbalanced magnetron.

15. An evaporation source according to anyone of the preceding claims, wherein the evaporation source is configured as an evaporation cathode or evaporation anode in such a way that the evaporation cathode can be used both as a sputtering cathode and as an arc evaporation source, in particular as an arc cathode.

## Revendications

1. Une source d'évaporation cylindrique, qui comprend un matériau cible (3) à vaporiser, une première source de champ magnétique (401), une seconde source de champ magnétique (402) et un axe de rotation (D) sur une paroi extérieure du cylindre, dans laquelle la première source de champ magnétique (401) et la seconde source de champ magnétique (402) forment au moins une partie d'un système magnétique (400) et sont disposées à l'intérieur de la source d'évaporation cylindrique pour générer un champ magnétique, et la première source de champ magnétique (401) et la seconde source de champ magnétique (402) sont prévues sur un système de support (500) de telle sorte qu'une forme et / ou une intensité du champ magnétique peut être réglée selon un schéma prédéfinissable dans une région prédéterminée, et le système de support (500) est conçu pour régler la forme et / ou l'intensité du champ magnétique de telle sorte que la première source de champ magnétique (401) est disposée sur un premier bras de support (501) et est pivotant par rapport à un premier axe de pivotement (5011) autour d'un premier angle de pivotement prédéterminé (α₁), dans lequel la première source de champ magnétique (401) et la seconde source de champ magnétique (402) peuvent pivoter l'un contre l'autre, **caractérisé en ce que** le premier axe de pivotement (5011) et l'axe de rotation (D) sont différents l'un de l'autre.

2. Une source d'évaporation selon la revendication 1, dans laquelle la seconde source de champ magnétique (402) est disposée sur un second bras de support (502) et est pivotant par rapport à un second axe de pivotement (5021) autour d'un second angle de pivotement prédéterminé (α₂).

3. Une source d'évaporation selon l'une des revendications 1 ou 2, dans laquelle le système magnétique (400) comprend en outre un premier élément magnétique (403).

4. Une source d'évaporation selon l'une des revendications précédentes, dans laquelle le système magnétique (400) comprend en outre un second élément magnétique (404).

5. Une source d'évaporation selon l'une des revendications précédentes, dans laquelle la première source de champ magnétique (401) et / ou la seconde source de champ magnétique (402) et / ou le premier élément magnétique (403) et / ou le second élément magnétique (404) et / ou le système de support (500) peut être déplacé linéairement dans une direction spatiale prédéterminée.

6. Une source d'évaporation selon l'une des revendications précédentes, dans laquelle la première source de champ magnétique (401) et / ou la seconde source de champ magnétique (402) et / ou le premier élément magnétique (403) et / ou le second élément magnétique (404) et / ou le système de support (500) est disposé déplaçable linéairement dans une direction (RS) perpendiculaire à un axe longitudinal (L) du système de support (500), en particulier disposé déplaçable linéairement simultanément perpendiculaire à l'axe longitudinal (L) et parallèle à une bissectrice (WH) d'un angle de pivotement total (α₁₂).

7. Une source d'évaporation selon l'une des revendications précédentes, dans laquelle la première source de champ magnétique (401) et / ou la seconde source de champ magnétique (402) et / ou le premier élément magnétique (403) et / ou le second élément magnétique (404) et / ou le système de support (500) est disposé déplaçable linéairement dans une direction (RP) parallèle à l'axe longitudinal (L) du système de support (500).

8. Une source d'évaporation selon l'une des revendications précédentes, dans laquelle la première source de champ magnétique (401) et / ou la seconde source de champ magnétique (402) et / ou le premier élément magnétique (403) et / ou le second élément magnétique (404) et / ou le système de support (500) est disposé pour tourner autour d'un axe de rotation (D) d'un angle de rotation prédéterminé (β), dans lequel l'axe de rotation (D) est de préférence parallèle à l'axe longitudinal (L) du système de support (500).

9. Une source d'évaporation selon l'une des revendications précédentes, dans laquelle la première source de champ magnétique (401) et / ou la seconde source de champ magnétique (402) et / ou le premier élément magnétique (403) et / ou le second élément magnétique (404) et / ou le système de support (500) est disposé de manière à pouvoir être incliné autour d'un axe de basculement (K).

10. Une source d'évaporation selon l'une des revendications 3 à 9, dans laquelle le premier élément magnétique (403) et / ou le second élément magnétique (404) est disposé de préférence sur une culasse (410), en particulier sur une culasse (410) en matériau ferritique par rapport à la bissectrice (WH) de l'angle total de pivotement (α₁₂) à une distance prédéterminée de l'axe longitudinal (L) du système de support (500).

11. Une source d'évaporation selon l'une des revendications 3 à 10, dans lequel le premier élément magnétique (403) et / ou le second élément magnétique (404) est un aimant auxiliaire ou la culasse (410).

12. Une source d'évaporation selon l'une des revendications précédentes, dans laquelle la première source de champ magnétique (401) et / ou la seconde source de champ magnétique (402) et / ou le premier élément magnétique (403) et / ou le second élément magnétique (404) est un aimant permanent et / ou une ferrite et / ou un électro-aimant.

13. Une source d'évaporation selon l'une des revendications précédentes, dans laquelle une intensité du champ magnétique de la première source de champ magnétique (401) et / ou de la seconde source de champ magnétique (402) et / ou du premier élément magnétique (403) et / ou du second élément magnétique (404) est contrôlable ou réglable.

14. Une source d'évaporation selon l'une des revendications précédentes, dans laquelle le système magnétique (400) forme un magnétron équilibré ou non équilibré.

15. Une source d'évaporation selon l'une des revendications précédentes, dans laquelle la source d'évaporation est configurée comme cathode d'évaporation ou anode d'évaporation de telle sorte que la cathode d'évaporation peut être utilisée à la fois comme cathode de pulvérisation et comme source d'évaporation à arc, en particulier comme cathode à arc.
